# EUROPÄISCHE PATENTSCHRIFT

(11) **EP 1 029 103 B1**
(45) Veröffentlichungstag und Bekanntmachung des Hinweises auf die Patenterteilung: **19.09.2001**
(21) Anmeldenummer: 98959747.1
(22) Anmeldetag: 21.10.1998
(51) Int. Cl.: C23C 14/04, C23C 4/00

(54) **BESCHICHTUNGSVERFAHREN UND VORRICHTUNG**
COATING METHOD AND DEVICE
PROCEDE D'APPLICATION DE REVETEMENT ET DISPOSITIF

(30) Priorität: 03.11.1997 DE 19748539
(43) Veröffentlichungstag der Anmeldung: 23.08.2000
(73) Patentinhaber: SIEMENS AKTIENGESELLSCHAFT, 80333 München (DE)
(72) Erfinder: BEELE, Wolfram, D-40883 Ratingen (DE)
(86) Internationale Anmeldenummer: DE9803091
(87) Internationale Veröffentlichungsnummer: WO9923273

(56) Entgegenhaltungen:
- EP-A- 0 253 754
- EP-A- 0 467 623
- US-A- 5 364 667

## Beschreibung

Die Erfindung betrifft ein Beschichtungsverfahren zur Beschichtung eines Bauteils mit einer Oberfläche und einem an der Oberfläche an einer Mündung mündenden Kanal. Die Erfindung betrifft weiter eine Vorrichtung zur Durchführung des Beschichtungsverfahrens.

In der EP 0 253 754 A1 ist ein Beschichtungsverfahren beschrieben. Es wird eine Turbinenschaufel beschichtet, an deren Oberfläche Kühlkanäle münden. Ein Verschließen dieser Kühlkanäle durch die Beschichtung der Oberfläche wird dadurch verhindert, daß jeder Kühlkanal vor der Beschichtung mit einem Stopfen verschlossen wird. Ein solcher Stopfen verhindert das Eindringen von Beschichtungsmaterial in die Kühlkanalöffnung.

Aufgabe der Erfindung ist die Angabe eines Beschichtungsverfahrens, bei dem eine Verstopfung oder eine unzulässige Verengung einer Kanalmündung vermieden wird. Weitere Aufgabe der Erfindung ist die Angabe einer Vorrichtung zur Durchführung des Beschichtungsverfahrens.

Erfindungsgemäß wird die auf ein Beschichtungsverfahren gerichtete Aufgabe gelöst durch ein Beschichtungsverfahren zur Beschichtung eines Bauteils mit einer Oberfläche und einem an der Oberfläche an einer Mündung mündenden Kanal, wobei ein Beschichtungsmaterial auf die Oberfläche aufgebracht und gleichzeitig ein Fluid durch den Kanal aus der Mündung herausgeleitet wird, und wobei das Fluid vor dem Herausführen vorgewärmt wird, insbesondere auf eine Temperatur zwischen 100 °C bis 900 °C, vorzugsweise zwischen 400 °C und 700 °C.

Durch ein solches Beschichtungsverfahren wird verhindert, daß der Kanal bei der Beschichtung von Beschichtungsmaterial verstopft oder an der Mündung unerwünscht verengt wird. Dies wird dadurch erreicht, daß das aus der Mündung ausströmende Fluid das Beschichtungsmaterial zumindest teilweise verdrängt. Damit gelangen keine größeren Mengen des Beschichtungsmaterials in die Mündung. Über eine geeignete Einstellung des Drucks, mit dem das Fluid aus der Mündung ausströmt, kann geregelt werden, inwieweit Beschichtungsmaterial durch das Fluid verdrängt wird. Somit ist es möglich, die sich im Mündungsbereich des Kanals absetzende Menge an Beschichtungsmaterial, d.h. die sich dort ausbildende Schichtdicke, zu beeinflussen. Zusätzlich wird durch das Vorwärmen des Fluides vermieden, daß sich durch das Fluid um die Kühlkanalmündungen herum lokal abgekühlte Bereiche ergeben, oder daß sich insgesamt die Gasturbinenschaufel abkühlt. Ein nicht vorgewärmtes Fluid könnte somit durch eine solche, zumindest lokale, Abkühlung der Gasturbinenschaufel zu Schichtstrukturdefekten in der Beschichtung führen. In der Regel wird eine Gasturbinenschaufel nämlich beim Beschichten auf einer hohen Temperatur gehalten, um die Schichtgüte zu verbessern.

Bevorzugt weist die Mündung eine gegenüber der Oberfläche kleine Querschnittsfläche auf, insbesondere eine Querschnittsfläche kleiner als 2% der Oberfläche. Gerade kleine Kanäle können bei einer Beschichtung leicht verstopfen. Es ist nunmehr möglich, eine Beschichtung ohne die Gefahr einer Kanalverstopfung auch an solchen Bauteilen vorzunehmen, welche kleine Kanalmündungen an der Oberfläche aufweisen.

Bevorzugt wird als Bauteil ein heißgasbeaufschlagbares Bauelement einer thermischen Maschine verwendet. Weiter bevorzugt wird als Bauteil eine Turbinenschaufel, insbesondere eine Gasturbinenschaufel verwendet, wobei der Kanal ein Kühlkanal ist. Gasturbinenschaufeln weisen häufig eine innere Kühlstruktur auf, über welche sie durch eine Einleitung von kühlendem Gas kühlbar sind. Dabei münden auch Kühlkanäle an der heißgasbeaufschlagbaren Oberfläche. Aus diesen Kühlkanälen austretendes Kühlgas streicht an der Oberfläche des Schaufelblattes entlang und dient zur sogenannten Filmkühlung oder bei sehr feinen Känälen als Transpirationskühlung des Schaufelblattes. Um den hohen korrosiven und thermischen Beanspruchungen einer Gasturbinenschaufel begegnen zu können, ist diese zudem häufig mit einer Beschichtung versehen. Dabei kann sowohl eine Oxidations- oder Korrosionsschutzschicht als auch eine Wärmedämmschicht oder eine Kombination dieser Schichten zu einem Schichtsystem vorgesehen sein. Zudem kann auch eine die Wärmedämmschicht anbindende Zwischenschicht vorgesehen sein.

Eine solche Beschichtung ist in der Regel die das Revisionsintervall begrenzende Komponente einer Gasturbinenschaufel. Es ist oft wirtschaftlich sinnvoll, die Beschichtung einer solchen Gasturbinenschaufel von Zeit zu Zeit zu erneuern, um den Grundkörper hinsichtlich seiner Lebensdauer voll auszunutzen. Insbesondere bei der Erneuerung der Beschichtung einer Gasturbinenschaufel tritt das Problem auf, die Wirkung des Kühlsystems nicht durch ein Zusetzen von an der Oberfläche mündenden Kühlkanälen während der Beschichtung zu beeinträchtigen. Indem während des Beschichtungsverfahrens, also auch z.B. für jede einzelne Schicht eines oben genannten Schichtsystems, Fluid durch die Kühlkanäle gepreßt wird, kann eine Verstopfung oder eine unzulässige Verengung der Kühlkanäle unterbunden werden.

Bevorzugt wird eine Wärmedämmschicht, insbesondere auf Zirkonoxid-Basis aufgebracht.

Weiter bevorzugt wird eine Oxidations- und/oder Korrosionsschutzschicht aufgebracht, insbesondere eine MCrAlY-Schicht, die umfaßt:
- mindestens ein Metall aus der Gruppe Eisen, Kobalt, Nickel, abgekürzt mit M,
- Chrom (Cr)
- Aluminium (Al) und
- Yttrium (Y) und/oder Hafnium und/oder ein Metall aus der Gruppe der Seltenen Erden, insbesondere Scandium, Lanthan oder Cer.
Bevorzugt enthält die Oxidations- und/oder Korrosionsschutzschicht zusätzlich Rhenium, insbesondere in einer Konzentration von 1 Gew.% bis 15 Gew%.

Bevorzugt erfolgt die Beschichtung mit einem PVD-Beschichtungsverfahren (Physical Vapour Deposition). Weiter bevorzugt erfolgt die Beschichtung mittels eines Gasstrahl-Sputter-Verfahrens (GS-PVD-Verfahren), wobei das Beschichtungsmaterial durch Ionenbeschuß eines lonenstrahles aus einem Festkörperverbund herausgelöst wird, von dem Ionenstrahl zur Oberfläche mitgeführt und auf der Oberfläche abgeschieden wird. Bei einem Gasstrahl-Sputter-Verfahren wird ein Gas, vorzugsweise ein Inertgas wie Argon, an einer Anode ionisiert und zu einer Kathode hin beschleunigt. An der Kathode befindet sich in Festkörperform das Beschichtungsmaterial. Aus diesem Festkörper wird durch die auftreffenden Ionen Material herausgelöst und von dem ionisierten Argon zur Oberfläche des Bauteils geführt, wo es sich abscheidet.

Bevorzugt erfolgt die Beschichtung über das Gasstrahl-Sputter-Verfahren innerhalb einer Kammer, wobei in der Kammer ein Kammerdruck eingestellt wird, und wobei das Fluid mit einem gegenüber dem Kammerdruck um 0,02 bis 0,2 mbar erhöhten Druck aus der Mündung herausgeleitet wird. Für das Gasstrahl-Sputter-Verfahren hat sich der Überdruck gegenüber dem Kammerdruck für das ausströmende Fluid gemäß den obigen Angaben als ein besonders geeigneter Druck zur Steuerung der Ablagerung von Beschichtungsmaterial im Kanalmündungsbereich erwiesen.

Bevorzugt erfolgt die Beschichtung mittels eines thermischen Spritzverfahrens. Weiter bevorzugt erfolgt die Beschichtung mittels eines Plasma-Spritzverfahrens, insbesondere mittels eines Vakuum- oder Niedrigdruck-Plasma-Spritzverfahrens, wobei ein Ionenstrahl das Beschichtungsmaterial zur Oberfläche führt. Beim Plasma-Spritzverfahren wird zwischen einer Kathode, in der Regel eine Wolframkathode und einer Anode, in der Regel eine wassergekühlte, ringförmige Kupferanode, ein Lichtbogen gezündet, der das einströmende Plasmagas ionisiert und so ein Plasma erzeugt. In dieses wird mit hoher Geschwindigkeit über ein Trägergas das Beschichtungsmaterial eingedüst, aufgeschmolzen und vom Plasma zur Oberfläche des zu beschichtenden Bauteils geführt und dort abgeschieden. Abhängig von z.B. der Geschwindigkeit des Ionenstrahls herrscht am Ort des Auftreffens des Ionenstrahls, dem sogenannten Spot, ein Spotdruck.

Bevorzugtermaßen herrscht am Ort des Auftreffens des Plasmastrahls an der Oberfläche ein Spotdruck von 200 bis 600 mbar, wobei das Fluid unter einem Druck, der 20% bis 120% des Spotdruckes beträgt, insbesondere niedriger als der Spotdruck ist, aus der Mündung herausgeleitet wird. Weiter bevorzugt erfolgt die Beschichtung in einer Kammer, in der ein Kammerdruck erzeugt wird, wobei das Fluid unter einem Druck, der um 10% bis 40%, insbesondere etwa 20% über dem Kammerdruck liegt, aus der Mündung herausgeleitet wird.

Bevorzugt wird als Fluid ein Inertgas verwendet, insbesondere Argon. Die Verwendung eines Inertgases unterbindet eventuelle chemische Einflüsse des Fluides auf die Beschichtung.

Erfindungsgemäß wird die auf Angabe einer Vorrichtung gerichtete Aufgabe gelöst durch eine Vorrichtung zur Durchführung des Beschichtungsverfahrens an einer Gasturbinenschaufel mit an ihrer Oberfläche mündenden Kühlkanälen, bei der ein Inertgasbehälter vorgesehen ist, welcher mit der Gasturbinenschaufel strömungstechnisch verbindbar ist.

Anhand der Zeichnung wird die Erfindung an einem Ausführungsbeispiel näher erläutert. Es zeigen:
- FIG 1: ein in einer Beschichtungsvorrichtung angeordnetes Bauteil,
- FIG 2: einen Längsschnitt durch eine Beschichtung einer Gasturbinenschaufel und
- FIG 3: einen Längsschnitt durch einen Kühlkanal an der Oberfläche einer Gasturbinenschaufel während einer Beschichtung.

Gleiche Bezugszeichen haben in den verschiedenen Figuren die gleiche Bedeutung.

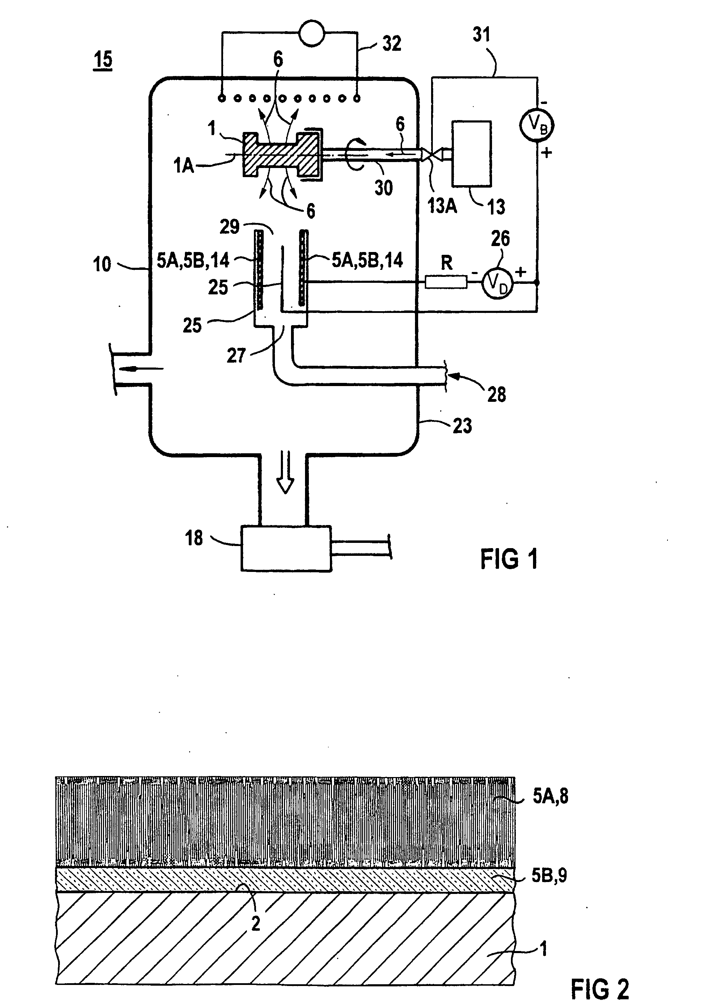

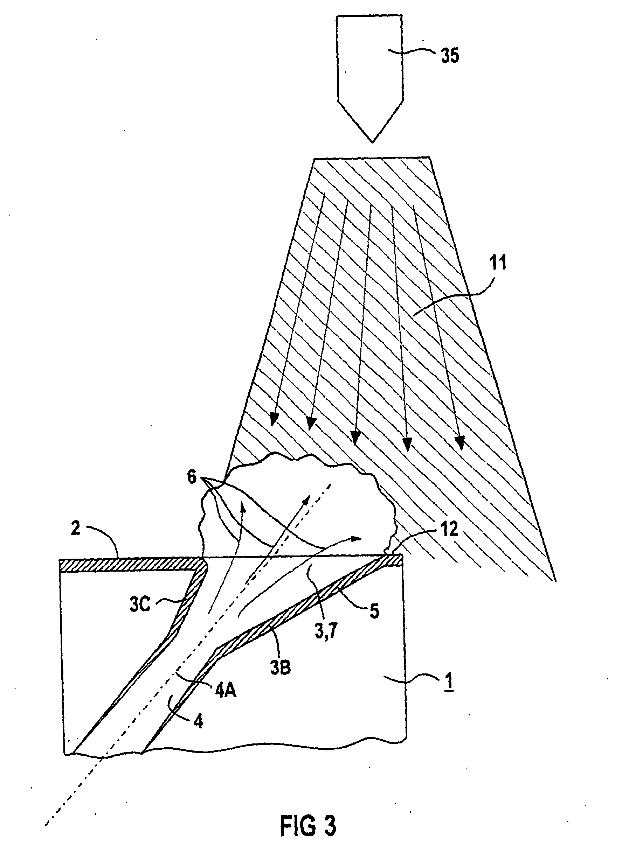

In Figur 1 ist schematisch und nicht maßstäblich der prinzipielle Aufbau einer Beschichtungsvorrichtung 15 zur Durchführung eines Gasstrahlsputter-Verfahrens dargestellt. Die Beschichtungsvorrichtung 15 weist ein Gehäuse 23 auf, in dem durch eine Vakuumpumpeinrichtung 18 ein Vakuum von unter 1 mbar, insbesondere etwa 0,5 mbar, erzeugbar ist. Innerhalb des Gehäuses 23 ist eine Hohlkathode 24 mit kreiszylindrischem Querschnitt angeordnet. Für die Beschichtung großer Bauteile können mehrere solcher Hohlkathoden oder eine lineare Hohlkathode mit rechteckigem Querschnitt, die entlang einer Längsachse ausgerichtet sind/ist, verwendet werden. Es kann auch eine sich trapezförmig öffnende Hohlkathode eingesetzt werden. Innerhalb der Hohlkathode 24 ist eine stabförmige Anode 25 angeordnet, die über eine Gleichspannunsversorgung 26 mit der Hohlkathode 24 verbunden ist. Die Gleichspannungsversorgung 26 erzeugt beispielsweise eine Gleichspannung von 400 V bis 800 V. Die Hohlkathode 24 weist in einem Festkörperverbund 14 ein Beschichtungsmaterial 5A, 5B auf, welches als Hohlzylinder ausgebildet ist oder beispielsweise aus einzelnen die Innenwandung der Hohlkathode 24 ausfüllenden Platten besteht. Die Hohlkathode 24 weist ein Außengehäuse mit einer Gaseinlaßöffnung 27 auf, die mit einer nicht dargestellten Gasversorgung verbunden ist, über die ein Inertgas 28, insbesondere Argon, in die Hohlkathode 24 eingeführwird. Der Gaseinlaßöffnung 27 gegenüberliegend hat die Hohlkathode 24 eine Gasauslaßöffnung 29, aus der das Inertgas 28 aus der Hohlkathode 24 herausströmt. Geodätisch oberhalb der Gasauslaßöffnung 29 ist ein Bauteil 1, eine Gasturbinenschaufel, in einer Halteeinrichtung 30 gehalten. Die Halteeinrichtung 30 ist über eine Zusatzspannungsversorgung 31 mit der Hohlkathode 24 elektrisch verbindbar. Eine zwischen die Hohlkathode 24 und die Halteeinrichtung 30 respektive das Bauteil 1 anlegbare Gleichspannung bewirkt eine Oberflächenreinigung des Bauteils 1 durch ionisierte Inertgasatome. Die Halteeinrichtung 30 hat vorzugsweise eine nicht näher dargestellte Antriebsvorrichtung, wodurch eine kontinuierliche Bewegung des Bauteils 1 um seine Längsachse 1A stattfindet. Geodätisch oberhalb des Bauteils 1 ist eine Beheizungseinrichtung 32 zur Beheizung des Bauteils über Wärmestrahlung und/oder Konvektion angeordnet. Die Beheizungseinrichtung 32 kann selbstverständlich je nach Anforderung auch auf gleichem geodätischem Niveau neben dem Bauteil 1 angeordnet sein. Ebenfalls können alle Konfigurationsangaben in umgekehrter geodätischer oder in horizontaler Anordnung ausgeführt werden. Die Gasturbinenschaufel 1 ist über die Halteeinrichtung 30 mit einem Inertgas-Behälter, vorzugsweise Argon, verbunden. Über die Öffnung eines Ventiles 13A kann Argon in die Gasturbinenschaufel 1 geleitet werden. Die Gasturbinenschaufel 1 weist Kühlkanäle 4 (s. Fig. 3) auf, welche an der Oberfläche 2 der Gasturbinenschaufel 1 münden. Aus diesen Kühlkanäle 4 strömt Argon während der Beschichtung aus, wodurch verhindet wird, daß die Kühlkanäle 4 verstopfen oder sich unzulässig verengen.

Fig. 2 zeigt einen Ausschnitt eines Längsschnittes durch eine Gasturbinenschaufel 1 mit einer Oberfläche 2. Auf die Oberfläche 2 ist Beschichtungsmaterial 5B, welches eine Oxidations- bzw. Korrosionsschutzschicht 9 aus MCrAlY bildet, aufgebracht. Auf die Oxidations- bzw. Korrosionsschutzschicht 9 ist Beschichtungsmaterial 5A als keramische Wärmedämmschicht 8 aufgebracht.

In Figur 3 ist ein Längsschnitt durch einen an der Oberfläche 2 einer Gasturbinenschaufel 1 an einer Mündung 3 mündenden Kühlkanal 4 gezeigt. Der Kühlkanal 4 führt entlang einer Achse 4B schräg zur Oberfläche 2 und erweitert sich in einer Ebene senkrecht zur Zeichenebene (und aus dieser Darstellung nicht erkennbar) trapezförmig. Der Längsschnitt durch die Mündung 3 ergibt eine erste Seite 3B und eine der ersten Seite gegenüberliegende zweite Seite 3C der Mündung 3. Die erste Seite 3B führt unter einem flachen Winkel zur Oberfläche 2. Damit wird erreicht, daß bei der Verwendung einer solchen Gasturbinenschaufel 1 in einer nicht dargestellten Gasturbinenanlage durch den Kühlkanal 4 austretendes Kühlgas einen Film bildend entlang der Oberfläche 2 austritt. Die sich trapezförmig erweiternde Mündung 3 fächert dabei das Kühlgas auf.

Im Ausführungsbeispiel gemäß Fig. 3 wird die Gasturbinenschaufel 1 durch ein Plasma-Spritzverfahren beschichtet. Dabei tritt aus einer nur schematisch dargestellten Plasma-Spritzkanone 35 ein Ionenstrahl 11 aus ionisiertem Argon aus. Dieser Ionenstrahl 11 führt Beschichtungsmaterial 5 mit sich. Das Beschichtungsmaterial 5 trifft auf die Oberfläche 2 an einem Ort 12, dem Spot, auf und setzt sich dort ab. Am Ort 12 herrscht abhängig u.a. von der Geschwindigkeit des Ionenstrahles 11 ein Spotdruck. Das Beschichtungsmaterial 5 trifft auch auf die Kanalwand 4A des Kanals 4 auf und setzt sich mit zunehmender Eindringtiefe in den Kanal 4 mit abnehmender Schichtdicke auf der Kanalwand 4A ab. Um nun zu verhindern, daß das Beschichtungsmaterial 5 die Mündung 3 zu sehr verengt oder gar verstopft, wird ein Fluid 6, hier Argon, aus dem Kühlkanal 4 herausgeleitet. Damit verdrängt das austretende Fluid 6 zumindest einen Teil des Beschichtungsmaterials 5 und verhindert somit eine unerwünscht hohe Abscheidung des Beschichtungsmaterials 5 im Bereich der Mündung 3. Es wird also eine unzulässige Verengung der Mündung 3 vermieden. Eine solche Verengung kann aufgrund der herabgesetzten Menge an durchleitbarem Kühlgas die Kühlleistung verringern. Zudem kann durch eine unzulässig hohe Abscheidung von Beschichtungsmaterial 5 insbesondere auf der Seite 3B der Mündung auch der Austrittswinkel des Kühlgases vergrößert und damit die Wirksamkeit der Filmkühlung reduziert werden. Indem eine unzulässige Verengung der Mündung 3 vermieden wird, bleibt die Qualität des Kühlsystems auch nach einem Beschichten der Gasturbinenschaufel 1 erhalten.

## Patentansprüche

1. Beschichtungsverfahren zur Beschichtung eines Bauteiles (1) mit einer Oberfläche (2) und einem an der Oberfläche (2) an einer Mündung (3) mündenden Kanal (4), wobei ein Beschichtungsmaterial (5A, 5B) auf die Oberfläche (2) aufgebracht und gleichzeitig ein Fluid (6) durch den Kanal (4) aus der Mündung (3) herausgeleitet wird und wobei das Fluid (6) vor dem Herausführen vorgewärmt wird, insbesondere auf eine Temperatur zwischen 100 °C und 900 °C.

2. Beschichtungsverfahren nach Anspruch 1,
bei dem die Mündung (3) eine gegenüber der Oberfläche (2) kleine Querschnittsfläche (7) aufweist, insbesondere eine Querschnittsfläche (7) kleiner als 2% der Oberfläche (2).

3. Beschichtungsverfahren nach Anspruch 1 oder 2,
bei dem als Bauteil (1) ein heißgasbeaufschlagbares Bauteil (1) einer thermischen Maschine verwendet wird.

4. Beschichtungsverfahren nach Anspruch 3,
bei dem als Bauteil (1) eine Turbinenschaufel, insbesondere eine Gasturbinenschaufel, verwendet wird, wobei der Kanal (4) ein Kühlkanal ist.

5. Beschichtungsverfahren nach Anspruch 3,
bei dem als Bauteil (1) ein Hitzeschild für eine Brennkammerauskleidung verwendet wird.

6. Beschichtungsverfahren nach einem der vorhergehenden Ansprüche, bei dem eine Oxidations- und/oder Korrosionsschutzschicht (9) aufgebracht wird, insbesondere aus MCrAlY, wobei MCrAlY umfaßt:
• mindestens ein Metall aus der Gruppe Eisen, Kobalt, Nickel, abgekürzt mit M,
• Chrom (Cr)
• Aluminium (Al) und
• Yttrium (Y) und/oder ein Metall aus der Gruppe der Seltenen Erden, insbesondere Scandium, Lanthan oder Cer.

7. Beschichtungsverfahren nach einem der vorhergehenden Ansprüche, bei dem eine Wärmedämmschicht (8), insbesondere auf Zirkonoxid-Basis, aufgebracht wird.

8. Beschichtungsverfahren nach einem der vorhergehenden Ansprüche, bei dem die Beschichtung mit einem PVD-Beschichtungsverfahren (Physical-Vapor-Deposition) erfolgt.

9. Beschichtungsverfahren nach Anspruch 8,
bei dem die Beschichtung mittels eines Gasstrahl-Sputterverfahrens (GS-PVD-Beschichtungsverfahren) erfolgt, wobei das Beschichtungsmaterial (5) durch Ionenbeschuß aus einem Festkörperverbund (14) herausgelöst und auf der Oberfläche (2) abgeschieden wird.

10. Beschichtungsverfahren nach Anspruch 9,
bei dem die Beschichtung innerhalb einer Kammer (10) erfolgt, wobei in der Kammer (10) ein Kammerdruck eingestellt wird und wobei das Fluid (6) mit einem gegenüber dem Kammerdruck um 0,02 bis 0,2 mbar erhöhten Druck aus der Mündung (3) herausgeleitet wird.

11. Beschichtungsverfahren nach einem der Ansprüche 1 bis 7 , bei dem die Beschichtung mittels eines thermischen Spritzverfahrens erfolgt.

12. Beschichtungsverfahren nach Anspruch 11,
bei dem als thermisches Spritzverfahren ein Plasma-Spritzverfahrens, insbesondere ein Vakuum- oder Niedrigdruck-Plasmaspritzverfahrens eingesetzt wird, wobei ein Ionenstrahl (11) das Beschichtungsmaterial (5) zur Oberfläche (2) führt.

13. Beschichtungsverfahren nach Anspruch 12,
bei dem am Ort (12) des Auftreffens des Ionenstrahles (11) an der Oberfläche (2) ein Spotdruck herrscht, insbesondere ein Spotdruck von 200 bis 600 mbar, wobei das Fluid (6) unter einem Druck, der 20% bis 120% des Spotdruckes beträgt, insbesondere niedriger als der Spotdruck ist, herausgeführt wird.

14. Beschichtungsverfahren nach Anspruch 12, das in einer Kammer erfolgt, in der ein Kammerdruck erzeugt wird, wobei das Fluid (6) unter einem Druck, der um 10% bis 40%, insbesondere etwa 20% über dem Kammerdruck liegt, aus der Mündung herausgeleitet wird.

15. Beschichtungsverfahren nach einem der vorhergehenden Ansprüche, bei dem als Fluid (6) ein Inertgas verwendet wird, insbesondere Argon.

16. Beschichtungsvorrichtung (15) zur Durchführung des Beschichtungsverfahrens an einer Gasturbinenschaufel (1) mit einem an ihrer Oberfläche (2) mündenden Kanal (4) nach einem der vorhergehenden Ansprüche, bei der ein Inertgasbehälter (13) vorgesehen ist, welcher mit der Gasturbinenschaufel (1) strömungstechnisch verbindbar ist.

## Claims

1. Coating process for coating a component (1) having a surface (2) and a duct (4), which opens out at an opening (3) at the surface (2), a coating material (5A, 5B) being applied to the surface (2) and, at the same time, a fluid (6) being conducted through the duct (4) out from the opening (3), and the fluid (6) being preheated prior to being conducted out, in particular preheated to a temperature of between 100°C and 900°C.

2. Coating process according to Claim 1, in which the opening (3) has a small cross-sectional area (7) relative to the surface (2), in particular a cross-sectional area (7) of less than 2% of the surface (2).

3. Coating process according to Claim 1 or 2, in which a thermal machine component (1) that can be exposed to hot gas is used as the component (1).

4. Coating process according to Claim 3, in which a turbine blade, in particular a gas turbine blade, is used as the component (1), the duct (4) being a cooling duct.

5. Coating process according to Claim 3, in which a thermal shield for a combustion chamber lining is used as the component (1).

6. Coating process according to one of the preceding claims, in which an anti-oxidation and/or -corrosion layer (9) is applied, in particular made of MCrAlY, where MCrAlY comprises:
• at least one metal from the group iron, cobalt, nickel, abbreviated to M,
• chromium (Cr)
• aluminium (Al) and
• yttrium (Y) and/or a metal from the group of rare earth elements, in particular scandium, lanthanum or cerium.

7. Coating process according to one of the preceding claims, in which a thermal insulation layer (8), in particular based on zirconium oxide, is applied.

8. Coating process according to one of the preceding claims, in which the coating is carried out by means of a PVD coating process (Physical Vapour Deposition).

9. Coating process according to Claim 8,
in which the coating is carried out by means of a gas jet sputtering process (GS PVD coating process), the coating material (5) being released from a solid composite (14) by ion bombardment and being deposited on the surface (2).

10. Coating process according to Claim 9,
in which the coating is carried out within a chamber (10), a chamber pressure being set in the chamber (10) and the fluid (6) being conducted out from the opening (3) with a pressure which is increased by 0.02 to 0.2 mbar relative to the chamber pressure.

11. Coating process according to one of Claims 1 to 7,
in which the coating is carried out by means of a thermal spraying process.

12. Coating process according to Claim 11,
in which the thermal spraying process used is a plasma spraying process, in particular a vacuum or low-pressure plasma spraying process, an ion beam (11) guiding the coating material (5) to the surface (2).

13. Coating process according to Claim 12,
in which a spot pressure, in particular a spot pressure of 200 to 600 mbar, prevails at the place (12) where the ion beam (11) impinges on the surface (2), the fluid (6) being passed out under a pressure which is 20% to 120% of the spot pressure, in particular is less than the spot pressure.

14. Coating process according to Claim 12, which is carried out in a chamber in which a chamber pressure is generated, the fluid (6) being conducted out from the opening under a pressure which is 10% to 40%, in particular about 20%, above the chamber pressure.

15. Coating process according to one of the preceding claims, in which an inert gas, in particular argon, is used as the fluid (6).

16. Coating apparatus (15) for carrying out the coating process on a gas turbine blade (1) having a duct (4) opening out at its surface (2), according to one of the preceding claims, in which an inert gas container (13) is provided which can be flow-connected to the gas turbine blade (1).

## Revendications

1. Procédé d'application d'un revêtement sur un élément (1) ayant une surface (2) et un canal (4) débouchant à la surface (2) en une embouchure (3), une matière (5A, 5B) de revêtement étant déposée sur la surface (2) et, en même temps, un fluide (6) sortant par le canal (4) de l'embouchure (3) et le fluide (6) étant préchauffé avant de sortir, notamment à une température comprise entre 100°C et 900°C.

2. Procédé de revêtement suivant la revendication 1, dans lequel l'embouchure (3) a une surface (7) de section transversale petite par rapport à la surface (2), notamment une surface (7) de section transversale représentant moins de 2% de la surface (2).

3. Procédé de revêtement suivant la revendication 1 ou 2, dans lequel on utilise comme élément (1) un élément (1) d'une machine thermique, qui peut être exposé à du gaz chaud.

4. Procédé de revêtement suivant la revendication 3, dans lequel on utilise comme élément (1) une aube de turbine, notamment une aube de turbine à gaz, le canal (4) étant un canal de refroidissement.

5. Procédé de revêtement suivant la revendication 3, dans lequel on utilise comme élément (1) un bouclier thermique pour un revêtement de chambre de combustion.

6. Procédé de revêtement suivant l'une des revendications précédentes, dans lequel on dépose une couche (9) de protection vis à vis de l'oxydation et/ou de la corrosion, notamment en MCrAIY, MCrAIY comprenant :
• au moins un métal du groupe du fer, du cobalt, du nickel, abrégé en M,
• du chrome (Cr)
• de l'aluminium (AI) et
• de l'yttrium (Y) et/ou un métal du groupe des terres rares, notamment du scandium, du lanthane ou du cérium.

7. Procédé de revêtement suivant l'une des revendications précédentes, dans lequel on dépose une couche (8) calorifuge, notamment à base d'oxyde de zirconium.

8. Procédé de revêtement suivant l'une des revendications précédentes, dans lequel on effectue le revêtement par un procédé de revêtement par dépôt physique en phase vapeur (Physical-Vapour-Deposition).

9. Procédé de revêtement suivant la revendication 8, dans lequel on effectue le revêtement au moyen d'un procédé de pulvérisation cathodique à jet de gaz (procédé de revêtement GS-PVD), la matière (5) de revêtement étant séparée, par bombardement ionique, d'un corps (14) composite solide et étant déposée sur la surface (2).

10. Procédé de revêtement suivant la revendication 9, dans lequel on effectue le revêtement dans une chambre (10) et en faisant sortir le fluide (6) de l'embouchure (3) sous une pression plus grande que celle de la pression régnant dans la chambre de 0,02 à 0,2 mbar.

11. Procédé de revêtement suivant l'une des revendications 1 à 7, dans lequel on effectue le revêtement au moyen d'un procédé de pulvérisation thermique.

12. Procédé de revêtement suivant la revendication 11, dans lequel on utilise comme procédé de pulvérisation thermique un procédé de pulvérisation au plasma, notamment un procédé de pulvérisation au plasma sous vide ou sous basse pression, un faisceau (11) d'ions guidant la matière (5) de revêtement vers la surface (2).

13. Procédé de revêtement suivant la revendication 12, dans lequel il règne à l'emplacement (12) où le faisceau (11) d'ions arrive sur la surface (2) une pression ponctuelle, notamment une pression ponctuelle de 200 à 600 mbars, le fluide sortant sous une pression qui représente de 20% à 120% de la pression ponctuelle, notamment qui est plus basse que la pression ponctuelle.

14. Procédé de revêtement suivant la revendication 12, qui s'effectue dans une chambre dans laquelle il est produit une pression, le fluide (6) sortant de l'embouchure sous une pression qui est supérieure de 10% à 40%, notamment de 20% environ à la pression régnant dans la chambre.

15. Procédé de revêtement suivant l'une des revendications précédentes, dans lequel on utilise comme fluide (6) un gaz inerte, notamment de l'argon.

16. Dispositif (15) d'application d'un revêtement pour la mise en oeuvre du procédé sur une aube (1) de turbine à gaz, comprenant un canal (4) débouchant sur sa surface (2), suivant l'une des revendications précédentes, dans lequel il est prévu une cuve (13) de gaz inerte, qui peut communiquer du point de vue de la technique de l'écoulement des fluides avec l'aube (1) de turbine à gaz.
